# FASCICULE DE BREVET EUROPEEN

(11) **EP 3 029 523 B1**
(45) Date de publication et mention de la délivrance du brevet: **05.01.2022**
(21) Numéro de dépôt: 15197525.7
(22) Date de dépôt: 02.12.2015
(51) Int. Cl.: G03F 7/00

(54) **PROCEDE DE TRANSFERT D'AU MOINS UNE PARTIE D'UN FILM COMPOSITE SUR UNE MEMBRANE SOUPLE EN POLYMERE**
VERFAHREN ZUM TRANSFER MINDESTENS EINES TEILS EINER VERBUNDFOLIE AUF EINE FLEXIBLE POLYMERMEMBRAN
METHOD FOR TRANSFERRING AT LEAST ONE PORTION OF A COMPOSITE FILM ONTO A FLEXIBLE POLYMER MEMBRANE

(30) Priorité: 04.12.2014 FR 1461940
(43) Date de publication de la demande: 08.06.2016
(73) Titulaire: Commissariat à l'Énergie Atomique et aux Énergies Alternatives, 75015 Paris (FR)
(72) Inventeur: TAKACS, Hélène, 38000 GRENOBLE (FR); VIALA, Bernard, 38360 SASSENAGE (FR)
(74) Mandataire: INNOV-GROUP

(56) Documents cités:
- WO-A2-2005/004205
- US-A1- 2008 229 948
- HINES D ET AL: "Transfer printing methods for the fabrication of flexible organic electronics", JOURNAL OF APPLIED PHYSICS, AMERICAN INSTITUTE OF PHYSICS, US, vol. 101, no. 2, 16 janvier 2007 (2007-01-16), pages 24503-024503, XP012097480, ISSN: 0021-8979, DOI: 10.1063/1.2403836
- HAI LI ET AL: "A Universal, Rapid Method for Clean Transfer of Nanostructures onto Various Substrates", ACS NANO, vol. 8, no. 7, 22 juillet 2014 (2014-07-22), pages 6563-6570, XP055205261, ISSN: 1936-0851, DOI: 10.1021/nn501779y
- None

## Description

L'invention concerne un procédé de transfert d'au moins une partie d'un film composite sur une membrane souple en polymère. L'invention a également pour objet des procédés de fabrication d'un composant utilisant ce procédé de transfert.

Un film composite est un film qui comporte une matrice en polymère thermoplastique à l'intérieur de laquelle sont dispersées des particules conférant à ce film composite des propriétés physiques indispensables au fonctionnement d'un composant, l'exo-diamètre des particules étant compris entre 1 nm et 100 µm, et le volume des particules à l'intérieur du film composite représentant plus de 1 %, et avantageusement plus de 10%, du volume de ce film composite. Par la suite, on parle de « nanoparticules » lorsque ces particules dispersées à l'intérieur de la matrice ont un exo-diamètre compris entre 1 nm et 1 µm.

Des procédés connus de transfert d'un film composite sur une membrane souple comportent :
α) le dépôt du film composite directement sur un substrat rigide en un matériau autre qu'un polymère et dont l'épaisseur est strictement supérieure à l'épaisseur du film, le film composite présentant alors une face extérieure tournée du côté opposé au substrat rigide, puis
β) le transfert d'au moins une partie du film composite déposé sur le substrat rigide vers la membrane par tamponnage.

Par exemple, un tel procédé est décrit dans l'article suivant : H. Li et Al. « Universal, Rapid Method for Clean Transfer of Nanostructures onto various Substrates », ACS Nano, 2014.

Les procédés connus utilisent une solution ou une goutte d'eau pour provoquer le décollement du film composite du substrat rigide.

De l'état de la technique est également connu de :
- Hines D et Al : « Transfer printing methods for the fabrication of flexible organic electronics », Journal of Applied Physics, American Institute of Physics, US, Vol. 101, N°2, 16/01/2007,
- US2008/229948A1,
- WO2005/004205A2.

L'invention vise à proposer un procédé de transfert plus simple à mettre en œ uvre. Elle a donc pour objet un tel procédé de transfert conforme à la revendication 1.

Le procédé ci-dessus exploite le fait que lorsque le film composite est chauffé au-delà de la température de transition vitreuse, la force d'adhésion du film composite sur un polymère augmente, tandis que dans le même temps, la force d'adhésion de ce film composite sur un matériau qui n'est pas un polymère diminue. Ainsi, à l'issue du chauffage et de la compression de la membrane, la force d'adhésion du film sur la première zone est supérieure à la force d'adhésion du film sur le substrat rigide. On peut alors facilement transférer au moins une partie du film composite sur la membrane souple. En particulier, il n'est pas nécessaire d'avoir recours à des moyens supplémentaires pour provoquer la séparation entre le film composite et le substrat rigide. Par exemple, il n'est pas nécessaire d'utiliser une goutte ou de tremper le film composite dans une solution pour provoquer la séparation. Dans le procédé ci-dessus, un simple déplacement de la membrane vers sa position rétractée est suffisant pour arracher du substrat rigide la partie souhaitée du film composite.

Le procédé ci-dessus présente aussi l'avantage supplémentaire qu'il permet un transfert simple d'une partie du film composite sur de nombreuses membranes en différent polymère. En effet, la seule contrainte imposée sur le choix du matériau de la membrane est qu'elle soit réalisée en polymère. Il est donc possible de transférer la partie du film composite sur des membranes réalisées dans des matériaux différents du PDMS (polydiméthylsiloxane).

Enfin, dans le procédé ci-dessus, puisque le film composite est ramolli au moment où il est mis en contact avec la membrane, il est important que la première zone soit rigoureusement parallèle à la face extérieure du film composite lors de l'opération de compression. En effet, le moindre défaut de parallélisme se traduit immédiatement par une diminution de l'épaisseur du film composite à un endroit car le film est mou à ce moment là. De plus, si rien n'est fait, cette variation non contrôlée de l'épaisseur du film composite perdure même après que le film composite ait été refroidi. Or, il est très difficile d'obtenir un tel parallélisme avec un procédé classique de micro-tamponnage dans lequel la membrane est collée sur un substrat dur. Dans le procédé ci-dessus, cette difficulté est résolue en comprimant la membrane sur la face extérieure du film composite à l'aide d'un fluide. Cela garantit que la pression exercée par la membrane sur la face extérieure du film composite est parfaitement uniforme et donc que la première zone reste parallèle à la face extérieure lors de la compression. Ainsi, le procédé ci-dessus ne crée pas des variations non contrôlées de l'épaisseur du film composite.

Enfin, après avoir imaginé le procédé ci-dessus, les déposants ont découvert que la machine nécessaire pour comprimer la face avant de la membrane contre la face extérieure du film composite se rapproche de la machine de micro-tamponnage décrite dans la demande US2003/0159608. À ce sujet, les déposants soulignent que la demande US2003/0159608 décrit une machine conçue pour structurer un masque sur un substrat rigide pour réaliser de la lithographie. Dans US2003/0159608, il faut absolument éviter qu'une partie du masque soit transférée sur la membrane car cela détruirait la structure du masque. Ainsi, US2003/0159608 ne divulgue pas une machine pour transférer un film composite sur une membrane souple et ne suggère même pas que, moyennant quelques adaptations, cette machine pourrait être utilisée pour faire cela. De plus, la demande US2003/0159608 ne traite pas des films composites mais uniquement d'un masque en résine dépourvu de particule. Dans ces conditions, un homme du métier qui aurait cherché à améliorer les procédés connus de transfert d'un film composite sur une membrane souple en polymère ne pouvait pas trouver, sans effort inventif, ce document. De plus, avant qu'un homme du métier se mette à chercher un procédé qui permette d'utiliser la membrane souple comme un tampon, il aurait déjà fallu qu'il sache qu'il y avait un intérêt à faire cela. Or justement, l'idée d'utiliser la membrane souple directement comme un tampon fait seulement partie des connaissances personnelles des inventeurs et non pas de celles de l'homme du métier.

Les modes de réalisation de ce procédé de transfert peuvent comporter une ou plusieurs des caractéristiques des revendications dépendantes.

Ces modes de réalisation du procédé de transfert présentent en outre les avantages suivants :
- L'utilisation d'un tampon pour recouvrir une seconde zone de la face avant de la membrane permet de transférer seulement une partie du film composite sur la membrane et, en même temps, de découper le film composite.
- Placer le tampon en face d'une cavité du substrat rigide permet de remplir simplement cette cavité avec le matériau du film composite et aussi de graver le film composite autour de cette cavité.

L'invention a également pour objet un procédé de fabrication, sur une membrane souple en polymère, d'un composant comportant un film composite. Ce procédé de fabrication utilise le procédé de transfert revendiqué.

Dans le procédé ci-dessus, c'est directement la membrane souple qui est utilisée comme un tampon pour prélever au moins une partie utile du film composite. Ainsi, dans le procédé ci-dessus, contrairement aux procédés connus, il n'est pas nécessaire d'utiliser un tampon intermédiaire pour :
- prélever la partie souhaitée du film composite, puis
- la transporter jusqu'à la membrane souple, puis
- la déposer sur cette membrane souple.

Le fait d'utiliser la membrane souple directement comme un tampon permet ainsi d'éviter l'utilisation de ce tampon intermédiaire. Ce procédé de fabrication est donc plus simple.

On notera que pour simplifier les procédés de fabrication connus, les inventeurs ont exploité le fait que la membrane est, dans le cas particulier du composant fabriqué ici, souple et en polymère. Par ailleurs, utiliser une membrane souple comme un tampon n'est pas trivial, car la membrane a généralement des dimensions bien plus grandes que les dimensions des tampons intermédiaires jusqu'à présent utilisés. Ainsi, les procédés de tamponnage où le tampon est déplacé, manuellement ou par un robot, ne sont pas utilisables. En effet, puisque la membrane a souvent une surface bien plus grande que celle des tampons connus, la moindre erreur de parallélisme entre la membrane et la face extérieure du film composite se traduit par une variation non contrôlée de l'épaisseur du film composite. Or, le parallélisme requis n'est pas atteignable en déplaçant manuellement ou à l'aide d'un bras automatisé la membrane par rapport à la face extérieure du film composite. Ainsi, dans le procédé ci-dessus, il est proposé une autre méthode pour pousser la membrane contre le film composite. Cette autre méthode fonctionne même si la surface de la membrane est très grande. Ici, une surface très grande est une surface supérieure à 50 cm² ou 100 cm². Le procédé ci-dessus fonctionne même si la surface de la membrane est supérieure 0,3 m² ou 1 m². En effet, en comprimant la membrane contre la face extérieure du film composite à l'aide d'un fluide, on garantit que la pression exercée en tous points de sa surface est uniforme.

Les modes de réalisation de ce procédé de fabrication sur une membrane souple peuvent comporter une ou plusieurs des caractéristiques des revendications dépendantes.

Ces modes de réalisation du procédé de fabrication sur une membrane souple présentent en outre l'avantage suivant :
- Le fait que la face du substrat rigide soit lisse permet en plus de diminuer la rugosité de la face extérieure du film composite transféré sur la membrane souple.

L'invention a également pour objet un procédé de fabrication, sur un substrat rigide en un matériau autre qu'un polymère, d'un composant comportant un film composite. Ce procédé de fabrication utilise aussi le procédé de fabrication revendiqué.

Le procédé de fabrication ci-dessus permet d'éliminer simplement et efficacement une partie d'un film composite. Il est rappelé à ce sujet que les films composites sont difficiles à graver selon les procédés classiques de gravure humide ou sèche. En effet, étant donné que les films composites comportent au moins deux matériaux différents, c'est-à-dire la matrice en polymère thermoplastique et le matériau des particules, il est difficile, voire impossible, de trouver un produit qui dissout avec la même efficacité aussi bien la matrice que les particules. À cause de cette différence d'efficacité, la gravure du film composite est inhomogène, ce qui conduit à des bords de coupe irréguliers. À l'inverse, le procédé ci-dessus est plus simple et permet en plus d'obtenir des bords de coupe plus nets.

Les modes de réalisation de ce procédé de fabrication sur un substrat rigide peuvent comporter une ou plusieurs des caractéristiques des revendications dépendantes.

Ces modes de réalisation du procédé de fabrication sur un substrat rigide présentent en outre les avantages suivants :
- Utiliser un tampon dont la face est lisse permet à la fois d'éliminer une partie du film composite déposé sur le substrat rigide tout en diminuant la rugosité des parties du film composite qui restent solidaires de ce substrat rigide.
- Utiliser un tampon qui comporte des motifs gravés dans sa face avant permet à la fois d'éliminer une partie du film composite déposé sur le substrat rigide tout en structurant la face extérieure des parties du film composite qui restent solidaires de ce substrat rigide.

L'invention sera mieux comprise à la lecture de la description qui va suivre, donnée uniquement à titre d'exemple non limitatif et faite en se référant aux dessins sur lesquels :
- la figure 1 est une illustration schématique, en coupe verticale, d'une partie de film composite déposée sur un substrat rigide,
- la figure 2 est une illustration schématique, en coupe verticale, d'une autre partie de film composite transférée sur une membrane souple ;
- la figure 3 est une illustration schématique, en coupe verticale, d'un appareil utilisé pour fabriquer les structures des figures 1 et 2 ;
- la figure 4 est un organigramme d'un procédé de transfert utilisé pour fabriquer les structures des figures 1 et 2 ;
- les figures 5 et 6 sont des illustrations schématiques, en coupe verticale, de l'appareil de la figure 3 dans différentes positions de fonctionnement ;
- la figure 7 est une illustration schématique, en coupe verticale, d'un composant fabriqué sur une membrane souple ;
- la figure 8 est un organigramme d'un procédé de fabrication du composant de la figure 7 ;
- la figure 9 est une illustration schématique, en coupe verticale, d'un composant fabriqué sur un substrat rigide ;
- la figure 10 est un organigramme d'un procédé de fabrication du composant de la figure 9 ;
- la figure 11 est une illustration schématique, partielle et en coupe verticale, d'une partie d'un composant ;
- la figure 12 est un organigramme d'un procédé de fabrication du composant de la figure 11.

Dans ces figures, les mêmes références sont utilisées pour désigner les mêmes éléments. Dans la suite de cette description, les caractéristiques et fonctions bien connues de l'homme du métier ne sont pas décrites en détail.

Dans cette description, on décrit d'abord le transfert d'un film composite sur une membrane souple. Ensuite, des procédés de fabrication d'un composant utilisant un tel transfert sont décrits.

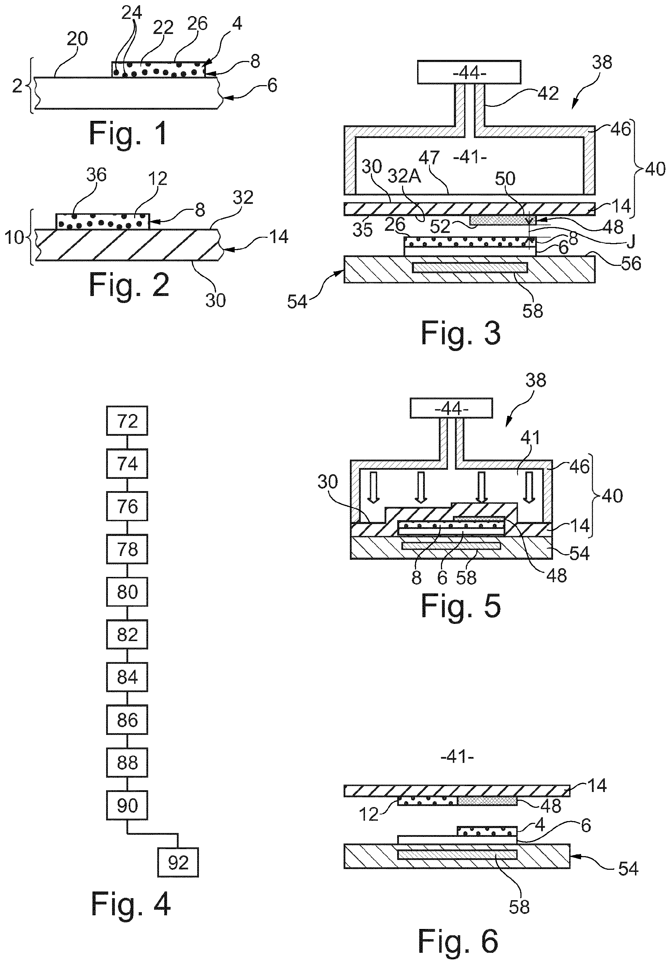

La figure 1 représente un empilement 2 d'une partie 4 d'un film composite 8 déposé sur un substrat rigide 6. Cet empilement 2 est obtenu en mettant en œuvre le procédé de transfert de la figure 4.

La figure 2 représente un empilement 10 d'une autre partie 12 du même film composite 8 sur une membrane souple 14. Cet empilement 10 est également obtenu à partir du procédé de transfert de la figure 4.

Par la suite, les termes « supérieur », « inférieur », « au-dessus », « en dessous », « haut », « bas » sont définis par rapport aux directions d'empilement, c'est-à-dire les directions perpendiculaires aux plans dans lesquels s'étendent principalement, respectivement, la membrane 14 et le substrat 6. Ici ces directions d'empilement sont verticales.

Le substrat 6 s'étend principalement dans un plan horizontal. Le substrat 6 est réalisé dans un matériau qui n'est pas un polymère. Typiquement, le substrat 6 est aussi réalisé dans un matériau inorganique. Par « matériau inorganique », on désigne ici un matériau dénué de carbone, c'est-à-dire un matériau comprenant moins de 1 % en masse et, de préférence moins de 0,1 % en masse, de carbone. Typiquement, le substrat 6 est un substrat minéral tel qu'un substrat minéral monocristallin ou un substrat minéral céramique. Par exemple, le matériau du substrat 6 est choisi dans le groupe composé du silicium, du verre, de la silice, de l'alumine, des oxydes métalliques ou dans le groupe composé des céramiques suivantes : PZT, AIN. L'oxyde métallique est par exemple le MgO.

Ici, le substrat 6 est un substrat en silicium dont la face supérieure 20 est constituée par une couche d'oxyde de silicium de 500 nm d'épaisseur.

L'épaisseur du substrat 6 est supérieure à l'épaisseur du film 8 et, généralement, supérieure à 10 µm ou 20 µm. Son module de Young à 20°C est généralement supérieur à 100 GPa. De plus, si le matériau du substrat 6 présente une température de transition vitreuse, alors celle-ci est supérieure d'au moins 50°C et, de préférence, plus de deux ou trois fois supérieure à celle de la matrice du film composite 8. De même, si le matériau du substrat 6 présente une température de fusion, celle-ci est très élevée, c'est-à-dire supérieure à 200°C ou 350°C.

Le substrat 6 présente une face supérieure 20 directement en contact mécanique avec une face inférieure de la partie 4 du film 8. Ici, cette face 20 est plane et horizontale. Ici, la face 20 est hydrophile pour faciliter l'adhésion du film 8 sur cette face. De préférence, la face 20 est également lisse pour faciliter le dépôt du film 8.

Dans cette description, par « lisse » on désigne une face d'une couche ou d'un substrat dont la rugosité RMS (Root Mean Square) est au moins inférieure à 20 % ou 25 % de l'épaisseur de la couche ou du substrat. De préférence, la rugosité RMS est inférieure à l'exo-diamètre moyen des nanoparticules du film 8 et, typiquement, deux ou trois ou dix fois inférieure à cet éxo-diamètre moyen. Généralement, la rugosité d'une face lisse est donc inférieure à 1 µm et, de façon encore plus avantageuse, inférieure à 100 nm ou 50 nm ou 10 nm. La rugosité RMS est mesurée sur une surface de 100 µm² ou de 1 µm², à l'aide d'un microscope à force atomique, plus connu sous l'acronyme AFM (Atomic Force Microscopy) ou d'un profilomètre selon la hauteur des aspérités à mesurer. Quelle que soit la rugosité de la face, celle-ci est uniquement créée par des aspérités réparties aléatoirement sur toute cette face. Autrement dit, la face n'est pas structurée. Dans cette description, par « face structurée », on désigne ici le fait que des motifs, tels que des rainures ou des trous, sont gravés dans cette face à des endroits prédéterminés. La profondeur de ces motifs est supérieure à 10 nm ou 50 nm et, typiquement, supérieure à 1 µm ou 20 µm.

Dans ce mode de réalisation, la partie 4 du film 8 recouvre uniquement une partie de la face 20. Par exemple, la partie 4 recouvre moins de 90 % et, généralement, moins de 70 % ou 50 % de la surface de la face 20. La partie 4 est directement déposée sur la face 20.

L'épaisseur du film 8 est typiquement comprise entre 100 nm et 10 µm et, de préférence, entre 100 nm et 3 µm. Ici, l'épaisseur du film 8 est égale à 2 µm à plus ou moins 20 % près.

Le film 8 comporte une matrice 22 en polymère thermoplastique à l'intérieur de laquelle sont dispersées des nanoparticules 24. Pour simplifier la figure 1, la référence 24 est indiquée uniquement pour quelques-unes des nanoparticules représentées par des points noirs.

La matrice 22 remplit les interstices entre les nanoparticules 24 pour les lier mécaniquement entre elles. Cette matrice 22 est réalisée en un polymère thermoplastique qui présente une température de transition vitreuse T_{g}. Par exemple, la température T_{g} est supérieure ou égale à 30°C ou 50°C. La température de la matrice 22 est mesurée selon la méthode décrite dans le document suivant : « Standard Test Method for Assignment of the Glass Transition Temperatures by Differential Scanning Calorimetry or Differential Thermal Analysis » (ASTM E 1356-98)..

Dans cette description, on désigne par « polymère » un polymère dont la masse molaire dépasse 1,5 kg/mol et, généralement, 2 kg/mol, en dessous c'est un oligomère. Un «polymère organique » est un polymère réalisé à partir de monomères composés d'atomes utilisés en chimie organique dont au moins le carbone et souvent aussi l'un des atomes suivants: H, O, et N. Par exemple, les formules chimiques de ces monomères ont la forme suivante : (-R1R2C-CR3R4-) ou (-R1C=CR2-) ou (-C°C-), où R1, R2, R3 et R4 sont des groupements organiques ou non. Un polymère inorganique est un polymère réalisé à partir de monomères composés d'atomes autres que le carbone. Par exemple, la formule chimique de ces monomère est la suivante : (-R1R2X1-X2R3R4-), où X1 et X2 ne sont pas du carbone. X1 et X2 peuvent être identiques ou non. Par exemple, X1 et/ou X2 sont des atomes de silicium.

La matrice 22 est ici réalisée dans un polymère organique thermoplastique. Par exemple, la matrice est réalisée en PS (Polystyrène) ou PMMA (poly(méthacrylate de méthyle)).

Généralement, la matrice 22 est un matériau électriquement isolant ou très faiblement conducteur et non magnétique. Par « électriquement isolant », on désigne ici un matériau dont la résistivité électrique à 20°C est supérieure à 10 ⁶ Q.m ou 10 ⁸ Q.m ou 10¹⁰ Ω.m . Par « non magnétique », on désigne ici un matériau dépourvu de propriété magnétique mesurable.

Ici, la matrice 22 est réalisée en polystyrène.

Les nanoparticules 24 confèrent au film 8 des propriétés physiques. En absence de ces nanoparticules, le film 8 serait dépourvu de ces propriétés physiques et le composant qui incorpore une partie de ce film ne fonctionnerait donc pas. Les propriétés physiques en question sont typiquement des propriétés magnétiques, optiques, électriques ou thermiques.

Dans ce mode de réalisation, les nanoparticules 24 sont des particules dont l'exo-diamètre est supérieur à 1 nm et, de préférence, supérieur à 5 nm ou 10 nm. La notion d'exo-diamètre est bien connue en granulométrie. On rappelle simplement ici que le «diamètre de Féret» (Df) est la plus petite distance entre une première droite donnée D1 et une seconde droite D2 parallèle à la droite D1. Ces droites D1 et D2 sont disposées de telle sorte que l'ensemble de la projection orthogonale de la particule dans le plan contenant ces deux droites parallèles soit comprise entre ces deux droites parallèles. De plus, ces deux droites D1 et D2 touchent chacune en au moins un point la périphérie de cette projection orthogonale de la particule. Si l'on fait tourner la droite D1 tout autour de la particule, on trouve une position de la droite D1 pour laquelle le diamètre Df est maximal. La valeur maximale du diamètre Df est l'exo-diamètre. La valeur minimale du diamètre Df est le méso-diamètre. Le rapport de la surface maximale de la projection de la particule sur la surface du cercle ayant un diamètre égal à l'exo-diamètre définit ce que l'on nomme l'indice de forme de la particule. La surface maximale de la projection de la particule est la surface de la projection orthogonale de la particule sur un plan, ce plan étant celui qui maximise cette surface.

L'exo-diamètre des nanoparticules est aussi strictement inférieur à l'épaisseur du film 8 et, de préférence, au moins deux ou trois fois inférieur à l'épaisseur du film 8. Typiquement, l'exo-diamètre des nanoparticules est inférieur à 1 µm et, généralement, inférieur à 150 nm. L'indice de forme des nanoparticules 24 est par exemple compris entre 0,5 et 1,5 et, souvent, compris entre 0,8 et 1,2. Ici, l'exo-diamètre des nanoparticules 24 est compris entre 20 et 50 nm et, par exemple, entre 30 et 50 nm.

Les nanoparticules 24 représentent plus de 1 % et, typiquement, plus de 10 % et, avantageusement, plus de 20 % ou 30 % ou 50 % du volume du film 8. Le pourcentage volumique des nanoparticules 24 dans le film 8 peut même dépasser 90 % selon les applications envisagées.

Dans cet exemple, toutes les nanoparticules 24 sont réalisées dans le même matériau. Ce matériau est différent de celui de la matrice 22 pour conférer les propriétés physiques souhaitées au film 8. Par exemple, les nanoparticules 24 sont ici réalisées en cobalt pour conférer des propriétés magnétiques au film 8. Dans ce cas, les nanoparticules 24 sont plus dures que la matrice 22.

Le film 8 présente une face plane supérieure 26 tournée vers le haut.

Dans la figure 2, la membrane 14 s'étend essentiellement dans un plan horizontal. Elle présente une face arrière 30, et du côté opposé, une face avant 32 parallèle à cette face arrière 30. La membrane 14 est souple. Par « souple », on désigne ici le fait qu'elle est capable, en absence de tout élément déposé ou fixé sur ses faces, de se déformer uniformément quand sa face arrière est comprimée par un fluide. Pour cela, typiquement, son épaisseur est inférieure à 1 mm et, avantageusement, inférieure à 500 µm ou 100 µm. Elle est réalisée dans un polymère apte à se déformer, au moins en flexion, autour de points d'ancrage situés sur sa périphérie. Typiquement, le module de Young à 25°C du polymère de la membrane 14 est inférieur à 3 GPa ou 1 GPa et, de préférence, inférieur à 0,5 GPa. Ici, elle est réalisée dans un polymère thermoplastique et, plus précisément, un polymère organique thermoplastique. Avantageusement, ce polymère est aussi un élastomère. Typiquement, le polymère est choisi dans le groupe composé du PC (polycarbonate), PP (Polypropylène), PE (Polyéthylène), PMMA (poly(méthacrylate de méthyle)), PVC (Polychlorure de vinyle) et PVDF (polyfluorure de vinylidène). Par contre, la membrane 14 n'est pas réalisée en PDMS (polydiméthylsiloxane).

La surface de la face 32 est ici supérieure à 20 cm² ou 50 cm², et typiquement supérieure ou égale à 100 cm² ou 500 cm². La surface de la face arrière 30 est égale à la surface de la face 32.

La face 32 n'a pas besoin d'être lisse. Par exemple, elle présente généralement une rugosité supérieure à l'exo-diamètre moyen des nanoparticules 24 et, typiquement, deux ou trois ou dix fois supérieure à cet éxo-diamètre moyen des nanoparticules 24. La rugosité de la face 32 est uniquement créée par des aspérités réparties aléatoirement sur toute cette face. Autrement dit, la face 32 n'est pas structurée et ne comporte pas de motif, par exemple régulier, gravé dans cette face 32.

La partie 12 du film composite 8 présente une face extérieure 36 tournée du côté opposé à la membrane 14. Cette face 36 est lisse. Ici, sa rugosité est égale à celle de la face 20 du substrat 6.

La figure 3 représente l'architecture d'un appareil 38 pour transférer la partie 12 du film 8 du substrat 6 vers la membrane 14. Cet appareil 38 est structurellement proche de ceux décrits dans la demande US2003/0159608. Par conséquent, seules les différences entre l'appareil 38 et les appareils décrits dans cette demande US2003/0159608 sont décrites en détail.

L'appareil 38 comporte un réservoir 40 délimitant une cavité intérieure 41 apte à contenir un fluide comprimé. Ici, le fluide est un gaz tel que de l'air. L'intérieur de la cavité 41 est raccordé fluidiquement par un conduit 42 à un compresseur 44.

Le réservoir 40 comprend des parois rigides verticales 46 dont les bords inférieurs délimitent une ouverture 47.

L'appareil 38 comprend aussi une membrane flexible 14 mécaniquement indépendante du réservoir 40.

La membrane 14 est déplaçable, de façon réversible, entre une position démontée (représentée sur la figure 3) et une position montée (représentée sur la figure 5). Dans la position démontée, la membrane 14 est mécaniquement séparée des bords inférieurs des parois 46 de sorte qu'elle n'obture pas de façon étanche l'ouverture 47. Dans la position montée, la membrane 14 obture de façon étanche au fluide comprimé l'ouverture 47. Plus précisément, lorsque la membrane 14 est dans sa position montée, une portion centrale de sa face arrière 30 affleure directement à l'intérieur de la cavité 41. Typiquement, la portion centrale de la face 30 représente plus de 50 % et, avantageusement, plus de 90 % de la surface de la face 30.

La membrane est également déplaçable de façon réversible entre une position rétractée et une position active. Dans la position rétractée, une zone 32A de la face avant 32 est séparée par un jeu de la face 26. Cette zone 32A est donc directement exposée à l'extérieur. Dans sa position active, la zone 32A est directement en contact sur la face extérieure 26 du film 8. Dans la position rétractée, la distance la plus courte qui sépare la face avant 32 de la face supérieure 20 du substrat 6 est donc beaucoup plus grande que la distance qui sépare les faces 20 et 32 dans la position active.

Dans la figure 3, pour simplifier, dans la position à la fois rétractée et démontée, la membrane 14 est représentée comme étant située sous l'ouverture 47. Toutefois, en pratique, dans la position à la fois rétractée et démontée, la membrane n'est généralement pas située sous l'ouverture 47 mais le plus souvent à côté.

L'appareil 38 comporte, en vis-à-vis de l'ouverture 47, un support plan 54. Le support 54 présente une face 56 de réception tournée vers l'ouverture 47 et sur laquelle est déposé un empilement du film 8 sur le substrat 6. De préférence, cet empilement est monté, sans aucun degré de liberté, sur la face 56 lorsque la membrane 14 est dans sa position rétractée, puis démontée, après l'utilisation de l'appareil 38.

Dans ce mode de réalisation, dans la position montée, la totalité de la périphérie de la membrane 14 est coincée entre les bords inférieurs du réservoir 40 et la face supérieure 56 du support plan 54. Ainsi, ici, pour passer entre les positions démontée et montée, c'est l'ensemble du support 54 qui se déplace en translation verticale entre une position basse (représentée sur la figure 2) et une position haute (représentée sur la figure 5). Dans la position basse, le jeu qui sépare la face 56 de l'ouverture 47 est suffisamment important pour permettre l'introduction et, en alternance, le retrait de l'empilement du film 8 et du substrat 6 entre cette face 56 et l'ouverture 47. Dans la position haute, la face 56 comprime la périphérie de la membrane 14 sur les bords de l'ouverture 47 pour obturer cette ouverture de façon étanche au fluide comprimé. Lorsque le support 54 est dans sa position haute et que l'empilement du film 8 et du substrat 6 est présent sur la face 56, la membrane 14 est dans sa position montée et, à la fois, dans sa position active.

Sur la figure 3, la partie 12 du film 8 n'a pas encore été transférée sur la face avant 32 de la membrane 14.

Dans ce mode de réalisation, l'appareil 38 comporte un tampon 48 fixé sur une zone 50 de la face avant 32. La zone 50 est entièrement recouverte par le tampon 48 et n'est donc pas directement exposée à l'extérieure. A l'inverse, le tampon 48 ne s'étend pas au-delà de la zone 50 et, en particulier, ne recouvre pas la zone 32A.

Le tampon 48 comporte une face avant 52 et une face arrière. Ces faces avant 52 et arrière sont parallèles et situées chacune d'un côté opposé. Dans ce mode de réalisation, la face arrière est entièrement et directement en contact et collée, sans aucun degré de liberté, sur la zone 50. Seule la face avant 52 est destinée à venir directement en contact avec la face 26 du film 8 lors de l'exécution du procédé de la figure 4. Ici, la face 52 est lisse. La zone 32A n'est pas lisse.

La force d'adhérence de la face 52 sur la face 26 est strictement inférieure et, de préférence, au moins deux ou trois fois inférieure à la force d'adhérence du film 8 sur le substrat 6. Cela permet de ne pas arracher la partie du film 8 sur laquelle le tampon 48 vient en appui comme cela est expliqué en référence au procédé de la figure 4. A cet effet, le tampon 48 est réalisé dans un matériau inorganique et qui n'est pas un polymère. Typiquement, le matériau utilisé pour le tampon 48 est choisi comme précédemment décrit pour le substrat 6. Ici le matériau choisi est un matériau minéral. Par exemple, le tampon 48 est réalisé en silicium. Son épaisseur est alors supérieure à 50 µm, par exemple supérieure à 500 µm ou 750 µm.

L'appareil 38 comporte un élément chauffant 58 apte à chauffer le film 8 au-delà de la température T_{g}. Ici, l'élément chauffant 58 est logé, à titre d'exemple, à l'intérieur du support 54 et sous la face 56.

Le transfert de la partie 12 du film 8 du substrat 6 vers la membrane 14 va maintenant être décrit en référence au procédé de la figure 4 et à l'aide des figures 5 à 6.

Le procédé de transfert débute par le dépôt 72 du film 8 sur la face 20 du substrat 6. Pour cela, on prépare une solution liquide contenant la matrice 22 et les nanoparticules 24 dans une proportion volumique connue qui conduira à la proportion volumique souhaitée pour la réalisation du film 8. Par exemple, on prépare une solution principalement constituée des nanoparticules 24, du polymère thermoplastique de la matrice 22 et d'un solvant dans lequel est dissout le polymère thermoplastique.

Ensuite, pour déposer le film 8 sur le substrat 6, on répartit la solution colloïdale sur toute la face supérieure 20 du substrat 6. Typiquement, cela est réalisé par enduction centrifuge plus connue sous le terme anglais de « spin coating ».

Après séchage, on obtient le film 8 déposé sur le substrat 6. À ce stade, le film 8 comprend à la fois les parties 4 et 12. Par exemple, le film 8 s'étend sur la totalité de la face 20. De plus, la face extérieure 26 du film 8 présente de nombreux défauts de planéité et une rugosité élevée. Typiquement, à ce stade, la rugosité RMS du film 8 est supérieure à cinq ou dix fois l'exo-diamètre moyen des nanoparticules 24. Il semble que cette rugosité élevée soit causée par des amas de nanoparticules 24 qui s'agglomèrent les unes aux autres lors de la réalisation du film 8. De plus, les défauts de planéité du film 8 sont aussi dus à des variations d'épaisseur de ce film. À ce stade de fabrication, il a été mesuré des écarts d'épaisseur du film 8 entre deux endroits différents pouvant atteindre et dépasser 0,5 µm ou 1 µm, voire même 2 µm.

Ensuite, lors d'une étape 74, l'empilement du film 8 sur le substrat 6 précédemment réalisé est placé sur la face 56 du support 54 en vis-à-vis de l'ouverture 47. Ensuite, le tampon 48 est déposé sur la partie 4 du film 8. En même temps ou après, la membrane 14 est déposée sur la face 26 du film 8. La zone 32A est alors directement en appui sur les parties 12 du film 8. La membrane 14 est alors dans sa position active. A ce stade, la membrane 14 et le tampon 48 sont retenus sur la face 26 uniquement par gravité. Le support 54 est dans sa position basse de sorte que la membrane 14 est dans sa position démontée et la pression à l'intérieur de la cavité 41 est égale à la pression atmosphérique. De même, à ce stade, la température du film 8 est égale à la température ambiante, c'est-à-dire inférieure à 25°C et à la température T_{g}.

Lors d'une étape 76, la membrane 14 est déplacée de sa position démontée vers sa position montée. Pour cela, le support 54 est déplacé de sa position basse jusqu'à sa position haute.

Une fois que la membrane est à la fois dans la position montée et dans la position active, lors d'une étape 78, le compresseur 44 comprime le fluide contenu à l'intérieur de la cavité 41 pour atteindre une pression strictement supérieure à la pression atmosphérique. Ici, il comprime le gaz, par exemple, à 6 bars (0,6 MPa). La membrane 14 se déforme alors et épouse complètement la forme du film 8 (figure 5). Sur la figure 5, les flèches verticales à l'intérieur de la cavité 41 représentent la pression qui s'exerce sur la face arrière 30 de la membrane 14 et donc sur la face extérieure 26. Cette pression est uniformément répartie sur toute la face 26, et ceci quelle que soit sa surface, car elle est exercée par l'intermédiaire d'un fluide.

Lors d'une étape 80, l'élément chauffant 58 est commandé pour chauffer le film 8 au-delà de la température T_{g} et tout en restant en deçà de sa température de fusion. La température de chauffage reste également inférieure à la température de transition vitreuse du substrat 6. En réponse à ce chauffage, le film 8 se ramollit. Par exemple, la température de chauffage est prise égale à 120°C et est maintenue pendant 1 min. Le ramollissement du film 8 augmente la force d'adhérence du film 8 sur les polymères et, dans le même temps, diminue sa force d'adhérence sur les matériaux qui ne sont pas des polymères. Ainsi, le ramollissement du film 8 augmente son adhérence sur la zone 32A et diminue son adhérence sur le substrat 6 et le tampon 48.

Lors d'une étape 82, une fois que le film 8 est ramolli, le compresseur 44 augmente la pression du fluide contenu à l'intérieur de la cavité 41 tout en maintenant le film 8 au-delà de sa température T_{g}. Par exemple, lors de l'étape 82, la pression à l'intérieur de la cavité 41 passe à 40 bars (4 MPa). Cette pression est maintenue pendant 5 min. Ainsi, pendant l'étape 82 la zone 32A de la membrane 14 adhère fortement sur la partie en vis-à-vis du film 8. Cette partie en vis-à-vis est celle destinée à devenir la partie 12 du film 8 après son transfert sur la membrane 14. Dans le même temps, la face 52 écrase fortement la partie du film 8 en vis-à-vis. Toutefois, le film 8 n'adhère pas sur la face 52 car cette face est réalisée dans un matériau qui n'est pas un polymère. La partie du film 8 en vis-à-vis du tampon 48 est celle qui deviendra la partie 4 après le transfert.

Lors d'une étape 84, l'élément chauffant 58 est commandé pour ramener la température du film 8 en dessous de la température T_{g}. Par exemple, l'élément chauffant 58 est éteint. Par conséquent, le film 8 durcit à nouveau dès que sa température redescend au-dessous de la température T_{g}.

Lors d'une étape 86, une fois que la température du film 8 est redescendue au-dessous de la température T_{g}, le compresseur 44 redescend la pression à l'intérieur de la cavité 41 jusqu'à revenir à la pression atmosphérique.

Lors d'une étape 88, une fois que la pression du fluide à l'intérieur de la cavité 41 est redevenue égale à la pression atmosphérique, la membrane 14 est déplacée vers sa position démontée en déplaçant le support 54 de sa position haute jusqu'à sa position basse.

Ensuite, lors de l'étape 90, la membrane 14 est déplacée de sa position active jusqu'à sa position rétractée. Par exemple, un coin de la périphérie de la membrane 14 est pincé puis tiré vers le haut jusqu'à détacher complètement la membrane 14 du substrat 6. Faire cela est fréquemment appelé « peler » la membrane 14. La partie 12 du film 8 collée sur la zone 32A est alors arrachée du substrat 6 (figure 6). En même temps, la face 52 est séparée de la face 26 du film 8. Ainsi, seule la partie 4 du film 8 reste solidaire du substrat 6. A l'issue de l'étape 88, on obtient donc simultanément, d'un côté, l'empilement 2 et, de l'autre côté, l'empilement 10. À ce stade, la rugosité de la face 36 du film 8 de l'empilement 10 est égale à celle de la face 20 à plus ou moins 10 % ou 5 % près. Par exemple, la rugosité de la face 36 est inférieure ou égale à 100 nm ou 50 nm. Ensuite, généralement, le tampon 48 est retiré ou éliminé, par exemple, en le décollant par gravure humide ou sèche. Le tampon 48 peut aussi être dissout par gravure humide ou sèche.

Ensuite, lors d'une étape 92, l'empilement 2 est retiré du support 54 et peut subir d'autres traitements. À ce stade, la planéité de la face 26 du film 8 de l'empilement 2 est considérablement améliorée. En effet, la rugosité de la face 26 est maintenant égale à celle de la face 52 à plus ou moins 10 % ou 5 % près. Par exemple, la rugosité de la face 26 est inférieure ou égale à 100 nm ou 50 nm.

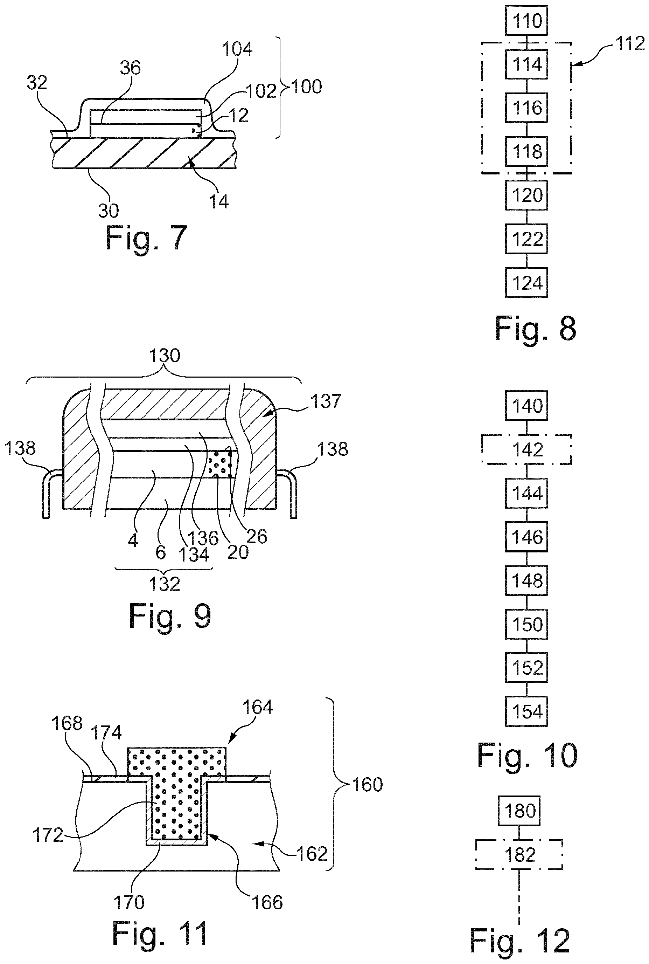

La figure 7 représente un composant 100 fabriqué et fixé sur la face 32 de la membrane 14. Ce composant 100 est un composant qui capte ou qui modifie ou qui émet un signal physique tel qu'un signal électromagnétique, optique ou électrique. Le composant 100 peut aussi traiter plusieurs de ces signaux. La suite de cette description est faite dans le cas particulier où le composant 100 est un composant qui convertit un signal électromagnétique en un signal électrique.

Seules les caractéristiques du composant 100 pertinentes pour la description de son procédé de fabrication sont décrites. Ainsi, sa représentation graphique a été extrêmement simplifiée et les facteurs d'échelle n'ont pas été respectés dans la figure 7. Cette remarque s'applique aussi aux figures 9 et 11.

Le composant 100 comporte, successivement empilé les uns au-dessus des autres dans la direction verticale et en allant du bas vers le haut, :
- la partie 12 du film 8 transférée sur la face 32 de la membrane 14,
- une couche fonctionnelle 102 directement déposée sur la partie 12 du film 8, et
- une couche 104 de passivation déposée sur la couche fonctionnelle 102.

La couche fonctionnelle 102 est nécessaire au fonctionnement du composant 100 après que sa fabrication ait été terminée. Elle est déposée directement sur la face 36. Son épaisseur est typiquement comprise entre 100 nm et 10 µm et, de préférence, entre 100 nm et 3 µm. Ici, cette couche fonctionnelle 102 est structurée pour former un motif, tel qu'un ou plusieurs brins d'une inductance ou d'une antenne, sur la face 36. Ainsi, dans ce mode de réalisation, elle ne recouvre pas la totalité de la face 36. Dans cet exemple, la couche fonctionnelle 102 est un brin en or déposé sur la partie 12 du film 8.

La couche 104 est, par exemple directement, déposée sur la couche fonctionnelle 102 pour la passiver, c'est-à-dire l'empêcher de réagir avec des éléments extérieurs. Par exemple, la couche 104 empêche que la couche 102 s'oxyde. Dans le cas particulier décrit ici, le composant est une antenne capable d'émettre ou de recevoir des ondes électromagnétiques par l'intermédiaire du brin en or.

La figure 8 représente un procédé de fabrication du composant 100. Ce procédé débute par une étape 110 de fabrication de la membrane 14.

Lors d'une phase 112, la partie 12 du film 8 est alors déposée sur la membrane 14.

Cette phase 112 débute par une étape 114 de mise en contact et de collage du tampon 48 sur la zone 50.

Ensuite, lors d'une étape 116, la membrane 14 est déplacée vers sa position active puis vers sa position montée comme décrit en référence au procédé de la figure 4.

Lors d'une étape 118, la partie 12 du film est alors transférée sur la membrane 14 comme décrit dans le procédé de la figure 4.

A l'issue de l'étape 90 du procédé de la figure 4, la phase 112 s'achève et le procédé se poursuit par :
- le dépôt, lors d'une étape 120, de la couche fonctionnelle 102 directement sur la face 36 de la partie 12 du film 8, puis
- la structuration, lors d'une étape 122, de la couche fonctionnelle 102 déposée pour former le brin de l'antenne, puis
- le dépôt, lors d'une étape 124, de la couche de passivation 104 sur la couche fonctionnelle 102 structurée.

Les étapes 120 et 122 sont réalisées selon des procédés classiques en microtechnologie de dépôt et de structuration de couches. Par exemple, le dépôt est réalisé par pulvérisation ou électro-déposition. Puis, la structuration de la couche 102 est réalisée par gravure sèche ou humide. Les étapes 120 et 122 peuvent aussi être réalisées à l'aide d'une imprimante à jet d'encre qui projette la couche 102 uniquement aux endroits souhaités sur la face 36. Dans ce cas, le dépôt et la structuration de la couche 102 ont lieu en même temps.

Malgré l'utilisation d'un procédé classique de dépôt de la couche fonctionnelle 102, celle-ci adhère très bien sur la face 36 de la partie 12 du film 8, car la planéité de cette face est très bonne à ce stade-là.

La figure 9 représente un composant 130 comportant la partie 4 du film 8 déposée sur le substrat rigide 6. Les fonctionnalités possibles du composant 130 sont identiques à celles décrites pour le composant 100. La suite de cette description est faite dans le cas particulier où le composant 130 est capable de convertir un signal électromagnétique en un signal électrique.

Sur la figure 9, les traits ondulés verticaux indiquent que des parties du composant 130 n'ont pas été représentées.

Le composant 130 comporte un empilement 132. Cet empilement 132 comporte successivement empilés les uns au-dessus des autres, dans la direction verticale et en allant du bas vers le haut :
- le substrat rigide 6,
- la partie 4 du film 8 directement déposée sur le substrat 6,
- une couche fonctionnelle 134 directement déposée sur la partie 4 du film 8, et
- une couche 136 de passivation déposée sur la couche fonctionnelle 134.

Ici, les couches 134 et 136 sont, par exemple, les mêmes que, respectivement, les couches 102 et 104.

L'empilement 132 est isolé mécaniquement de l'extérieur du composant 130 par une enveloppe protectrice 137 qui recouvre la majorité des faces de l'empilement 132. Ici, l'enveloppe 137 recouvre la face supérieure de l'empilement 132 et, éventuellement, aussi toutes les parois verticales de cet empilement 132. Elle est fixée sans aucun degré de liberté sur l'empilement 132. Par exemple, elle est collée sur cet empilement 132.

Cette enveloppe 137 est réalisée dans un matériau qui ne perturbe pas le fonctionnement de l'empilement 132. Ici l'enveloppe 137 est réalisée dans un matériau non magnétique et électriquement isolant comme par exemple une résine d'encapsulation (epoxy, silicone, vernis). De plus, pour remplir sa fonction protectrice, l'épaisseur de l'enveloppe 137 est généralement assez importante, c'est-à-dire supérieure ou égale à 10 µm ou 100 µm.

Enfin, le composant 130 a généralement besoin de communiquer ou d'échanger de l'énergie avec au moins un équipement situé à l'extérieur de l'enveloppe 137. À cet effet, il comporte des plots 138 de connexion par intermédiaire desquels il échange des informations et/ou de l'énergie avec cet équipement extérieur. Ces plots 138 sont fixés sans aucun degré de liberté sur la face extérieure de l'enveloppe 137. Par exemple, les plots 138 affleurent la face extérieure de l'enveloppe 137 ou font saillie au-delà de cette enveloppe 137.

Lorsque le signal échangé avec l'équipement extérieur est un signal électrique, ces plots 138 sont réalisés dans un matériau électriquement conducteur. Par « électriquement conducteur », on désigne ici un matériau dont la résistivité électrique à 20°C est inférieure à 10⁻⁶ Ω.m ou 1,5*10⁻⁸ Ω.m. Lorsque les signaux échangés sont des signaux optiques, les plots 138 sont dans un matériau transparent aux longueurs d'ondes des signaux optiques échangés.

La figure 9 représente le cas où des signaux électriques sont échangés et les plots 138 sont représentés sous la forme de broches électriques. Par exemple, l'un de ces plots 138 est électriquement raccordé au brin en or formé par la couche 134.

Le composant 130 peut comporter d'autres empilements ou des puces électroniques à l'intérieur même de l'enveloppe protectrice 137. Toutefois, pour simplifier l'illustration, ceux-ci n'ont pas été représentés.

La figure 10 représente un procédé de fabrication du composant 130. Ce procédé débute par une étape 140 de fabrication du substrat 6.

Lors d'une phase 142, le film composite est déposé sur le substrat 6 puis gravé ou en partie éliminé. Pour cela, la partie 12 du film 8 est transférée sur la membrane 14 tout en laissant la partie 4 solidaire du substrat 6. Cette phase 142 est ici identique à la phase 112.

A l'issue de l'étape 92 du procédé de la figure 4, la phase 142 s'achève et le procédé se poursuit par :
- le dépôt, lors d'une étape 144, de la couche fonctionnelle 134 directement sur la face 26 de la partie 4 du film 8, puis
- la structuration, lors d'une étape 146, de la couche fonctionnelle 134 déposée pour former le brin de l'antenne, puis
- le dépôt, lors d'une étape 148, de la couche de passivation 136 sur la couche fonctionnelle 134 structurée.

Les étapes 144 à 148 sont réalisées comme décrit pour les étapes 120 à 124. Comme dans le cas du procédé de la figure 8, malgré l'utilisation d'un procédé classique de dépôt de la couche fonctionnelle 136, celle-ci adhère très bien sur la face 26 de la partie 4 du film 8, car la planéité de cette face est très bonne à ce stade-là.

L'étape 148 peut être suivie d'une ou plusieurs phases 150 de réalisation d'autres empilements, tels que l'empilement 132, ou d'une ou plusieurs puces électroniques.

Ensuite, le procédé se poursuit par une étape 152 de réalisation des plots 138 de connexion et de raccordement électrique de ces plots. Enfin, lors d'une étape 154, l'enveloppe 137 est réalisée. Par exemple, l'enveloppe 137 est réalisée par moulage d'un polymère thermodurcissable.

La figure 11 représente une partie d'un composant 160 fabriqué sur un substrat rigide 162 qui n'est pas en polymère et comportant une partie 164 d'un film composite. Le substrat 162 est par exemple identique au substrat 6 sauf qu'il comporte au moins une cavité et, généralement plus de dix cavités, creusées dans sa face avant 168. Ici, pour simplifier la figure 11, seule une cavité 166 est représentée. Les autres cavités sont, par exemple, identiques à la cavité 166.

La partie 164 est située immédiatement au-dessus de la cavité 166 et obstrue complètement l'ouverture de cette cavité dans la face 168. À cet effet, la partie 164 déborde sur la face 168 tout autour de l'ouverture de la cavité 166.

Ici, la cavité 166 est un trou borgne comportant des parois verticales et un fond horizontal. La profondeur de la cavité 166 est strictement inférieure à l'épaisseur du film composite utilisé dans le procédé de la figure 12 avant qu'il soit écrasé par un tampon. Par exemple, la profondeur de la cavité 166 est supérieure à 0,1 µm, et généralement inférieure à 10 µm. La largeur de la cavité 166 est supérieure à 50 nm, et généralement inférieure à 1 µm, si celle-ci est réalisée par lithographie par faisceau d'électrons (e-beam). Cette largeur est par contre supérieure à 1 µm et généralement inférieure à 100 µm si la cavité 166 est réalisée par photolithographie (UV). Typiquement, les cavités sont espacées les unes des autres par une distance supérieure à leur largeur.

Les parois verticales et le fond horizontal de la cavité 166 sont recouverts d'un revêtement 170 électriquement conducteur tel qu'un revêtement métallique. De préférence, ce revêtement 170 est également hydrophile. Par exemple, le revêtement est réalisé en or ou en platine. Dans cet exemple, le revêtement 170 est en platine. Le revêtement 170 s'étend également, entre la partie 164 et la face avant 168, sur toute la périphérie de l'ouverture de la cavité 166. Ce prolongement du revêtement 170 sur la face 168 s'arrête à la limite de la partie 164 du film composite. Une couche 174 non métallique et par exemple en oxyde de silicium et recouvre le restant de la face 168 qui n'est pas situé sous une partie 164 du film composite.

L'intérieur de la cavité 166 est rempli d'un matériau 172 identique à celui du film composite. Ici, la partie 164 et ce matériau 172 ne forment qu'un seul bloc de matière.

La cavité 166 est ici fonctionnalisée, c'est-à-dire qu'elle est capable de remplir d'autres fonctions que simplement une connexion électrique entre différents éléments du composant 160. Ces autres fonctions sont rendues possibles par le matériau 172 de remplissage qui lui confère des propriétés physiques supplémentaires et donc cette capacité de remplir des fonctions supplémentaires. Ces fonctions supplémentaires peuvent être des fonctions électriques, diélectriques, magnétiques ou optiques, voire piézoélectriques ou magnéto-strictives ou magnéto-résistives.

Le composant 160 comporte aussi :
- une couche fonctionnelle,
- une couche de passivation, et
- si nécessaire, une enveloppe protectrice et des plots de connexion.
Ces différents éléments sont comme décrits en référence à la figure 9. Pour simplifier la figure 11, la couche fonctionnelle, la couche de passivation et l'enveloppe protectrice, ainsi que les connexions n'ont pas été représentées.

Le procédé de fabrication du composant 160 va maintenant être décrit en référence au procédé de la figure 12. Ce procédé débute par une étape 180 de fabrication du substrat 162. Cette étape 180 est par exemple identique à l'étape 140, sauf qu'elle comporte en plus la réalisation de la couche 174, puis la gravure dans la face 168 de la cavité 166 et enfin le dépôt du revêtement 170 à l'intérieur de la cavité 166.

Ensuite, lors d'une phase 182, un film du matériau 172 est déposé sur toute la face supérieure du substrat 162. Ce film est un film composite. Ensuite, il est structuré ou éliminé partiellement pour laisser subsister uniquement la partie 164 du film composite sur l'ouverture de chaque cavité 166. Cette phase 182 est identique à la phase 112 sauf qu'on utilise un tampon qui se trouve en vis-à-vis de l'ouverture de la cavité 166 et dont la face avant ne déborde pas au-delà du revêtement 170 lors de l'étape 82. En particulier, lors de l'étape 72, le film composite déposé recouvre toutes les cavités 166. De préférence, lors de cette étape 72, on réalise, par exemple par pompage, le vide entre le film composite déposé et la face 168. Lors de l'étape 82, comme précédemment, le tampon vient écraser la face 26 du film composite. Toutefois, ici, la pression exercée par ce tampon provoque aussi le remplissage complet de chaque cavité par le matériau du film composite. En effet, lors de l'étape 82, le film composite est ramolli. Ensuite, lors de l'étape 88, le retrait de la membrane 14 provoque l'arrachement des parties du film composite situé tout autour de l'ouverture de la cavité 166. Seules les parties du film composite, telles que la partie 164, restent solidaire du substrat 162.

Ensuite, après la phase 182, le procédé se poursuit par exemple, par les mêmes étapes de fabrication que celles décrites en référence au procédé de la figure 10 après la phase 142. Pour simplifier la figure 12, ces étapes suivantes 144 à 154 n'ont pas été représentées.

De nombreux autres modes de réalisation sont possibles. Par exemple, la face supérieure 20 du substrat 6 n'est pas nécessairement lisse. En variante, elle est structurée avant de déposer le film 8. Dans ces conditions, après le transfert de la partie 12 sur la membrane 14, la face 36 est elle aussi structurée mais avec un relief inversé.

Le substrat 6 peut être réalisé dans d'autres matériaux que du silicium oxydé en surface. Par exemple, le substrat 6 est réalisé en métal. Dans ce dernier cas, de préférence, il est recouvert d'un revêtement hydrophile non-organique. Ce revêtement hydrophile peut être un revêtement d'oxyde et de nitrure métallique, d'oxyde conducteur, semi-conducteur ou tout métal de préférence faiblement oxydable. Il peut par exemple s'agir d'or, de platine, de silicium, d'oxyde de silicium, de nitrure de silicium, de nitrure d'aluminium, ITO(Oxyde d'indium-étain), AZO, ... etc.

Le film 8 peut contenir un mélange de différentes espèces de nanoparticules. Ces différentes espèces de nanoparticules se distinguent les unes des autres, par exemple, par leur composition chimique. Ce qui a été décrit pour les nanoparticules 24 s'applique alors à chacune de ces espèces de nanoparticules.

En variante, l'adhérence de la membrane 14 sur le film 8 est augmentée en recouvrant au moins la zone 32A d'un revêtement organique hydrophile. Par exemple, le revêtement organique hydrophile de la face 32 est réalisé à partir d'un polymère hydrophile d'hydroxydes métalliques et d'amines. Par exemple, sa formule générale peut être M(OH)ₓ avec M choisi dans le groupe composé de Be, Mg, Ca, Sr, In, Ba, Ra, Al, Zn, Y et les polydopamines. L'indice x est typiquement un entier supérieur ou égal à un.

Tous les modes de réalisation décrits dans la demande US2003/0159608 peuvent être adaptés au procédé de la figure 4. L'adaptation consiste alors à remplacer la membrane et le tampon décrit dans cette demande US2003/0159608 par la membrane 14 et le tampon 48 décrits ci-dessus.

En variante, la face avant 52 du tampon 48 est réalisée dans un matériau hydrophobe ou rendu hydrophobe par greffage sur cette face, par exemple, de chaînes fluorées. Typiquement, dans ce cas, la totalité de la face 52 est hydrophobe.

Dans une autre variante, la face avant du tampon 48 est structurée. Le fait de structurer la face avant du tampon permet, lors de la compression de ce tampon contre le film composite ramolli, de structurer en plus la face 26 de la partie 4 du film composite qui reste solidaire du substrat rigide.

Le tampon 48 n'est pas nécessaire collé sur la zone 50 de la membrane. En variante il est simplement mis en contact non adhésif avec cette zone 50. Cela facilite le retrait de ce tampon 48 de la membrane 14. Par exemple, lors de l'étape 74, le tampon 48 est d'abord déposé sur la partie 4 du film 8. Ensuite, la membrane 14 est déplacée vers sa position active. Dès lors, le tampon 48 est interposé et coincé entre la partie 4 du film 8 et la membrane 14. Puis, les étapes 76 à 88 sont réalisées comme décrit précédemment. Enfin, lors de l'étape 90, le déplacement de la membrane 14 vers sa position rétractée entraîne en même temps sa séparation du tampon 48. Le tampon 48 est ensuite, à son tour, retiré pour le séparer de la partie 4 du film. Pour cela, le tampon 48 est par exemple simplement tiré vers le haut.

Le tampon 48 peut être omis dans tous les procédés décrits ici où un film composite doit être déposé sur une membrane en polymère. Dans ce cas, la zone 32A recouvre la totalité de la face avant 32. Dès lors, le procédé de la figure 4 conduit au transfert de la totalité du film 8 sur la membrane 14.

Dans un mode de réalisation particulier, la pression de la membrane 14 sur la face 26 du film 8 est obtenue en créant une dépression entre ces deux faces, plutôt qu'en augmentant la pression à l'intérieur de la cavité 41. Dans ce mode de réalisation, le fluide à l'intérieur de la cavité 41 n'est pas comprimé. Dans une autre variante de l'appareil 38, le fluide utilisé pour pousser la membrane 14 n'est pas un gaz mais un liquide.

Pour certaines applications de grande dimension, la surface de la face avant 32 peut dépasser 1 m² ou 2 m². Tout ce qui est a été décrit précédemment marche encore.

Plusieurs couches intermédiaires différentes peuvent être déposées entre la couche fonctionnelle 102 ou 134 et la couche de passivation 104 ou 136. Une ou plusieurs de ces couches intermédiaires peuvent être des films composites similaires au film 8. Dans ce cas, ces films composites supplémentaires sont déposés comme décrits pour le film 8.

La couche fonctionnelle 102 ou 134 peut être tout élément nécessaire au fonctionnement du composant. Par exemple, la couche fonctionnelle peut être structurée pour former une connexion électrique entre différents parties du composant.

En variante, l'étape 122 ou 146 de structuration de la couche fonctionnelle est omise. Dans ce cas, la couche fonctionnelle recouvre la totalité de la face 26 ou 36 des parties de film composite. Cette couche fonctionnelle peut également être réalisée dans de nombreux matériaux différents choisis en fonction de leur propriété physique. Par exemple, si la couche fonctionnelle doit être réalisée dans un matériau bon conducteur d'électricité, elle peut alors être réalisée en métal. La couche fonctionnelle peut aussi être réalisée dans d'autres matériaux ayant d'autres propriétés telles qu'un matériau piézoélectrique, un matériau électro-calorique ou un matériau ferromagnétique. La couche fonctionnelle peut aussi être un film composite, c'est-à-dire comporter une matrice à l'intérieur de laquelle sont dispersées des nanoparticules. Par exemple, la couche fonctionnelle est un film composite ayant des nanoparticules différentes de celles du film 8.

L'enveloppe protectrice 137 peut complètement envelopper l'empilement 132, c'est-à-dire recouvrir ses faces supérieure et inférieure, ainsi que ses parois verticales. Selon la fonction de l'empilement 132, l'enveloppe protectrice peut être réalisée dans d'autres matériaux. Par exemple, elle peut être réalisée en métal si le fonctionnement de l'empilement 132 est possible à l'intérieur d'une telle enveloppe protectrice en métal. Dans une variante simplifiée, l'enveloppe 137 est omise.

Dans certains modes de réalisation du composant 160, le revêtement 170 est omis. Il est aussi possible que la cavité 166 traverse de part en part le substrat 162. Dans ce cas, la cavité traversante est plus connue sous le terme de « via ». Dans une autre variante, la couche 174 s'étend également sous la partie 164 entre cette partie et la face 168.

Dans une autre variante, après l'étape 90 ou 92 ou après une autre étape ultérieure de fabrication du composant 100 ou 130 ou 160, le procédé comporte une étape de découpage de la membrane 14 ou du substrat 6 en plusieurs morceaux mécaniquement indépendants les uns des autres. Chacun de ces morceaux est alors incorporé dans un composant respectif mécaniquement indépendant des autres. On dit alors qu'il s'agit d'un procédé collectif de fabrication de ces différents morceaux d'empilement comportant chacun un film composite déposé sur une membrane ou un substrat.

Le passage par une pression intermédiaire avant d'appliquer une pression plus élevée peut être omis. Ceci est notamment le cas si la pression finale utilisée pour écraser la face 26 est inférieure à 10 bars (1 MPa). La pression utilisée pour écraser la face 26 est strictement supérieure à 1 bar et, généralement, supérieure à 6, 10 ou 30 bars. Elle est également généralement inférieure à 500 bars.

On peut aussi commencer à chauffer le film 8 avant de déplacer la membrane 14 dans sa position active.

Lors de l'étape 80, l'élément chauffant 58 peut chauffer le film 8 et la membrane 14 au-delà de leurs températures de transition vitreuse respectives. La force d'adhésion entre le film composite et la membrane est alors améliorée par le fait que la membrane et le film composite sont tous les deux ramollis.

La force d'adhésion du film composite sur la membrane peut aussi être améliorée si :
- des liaisons covalentes entre le film composite et la membrane sont créées lors du transfert, et dans le même temps,
- aucune liaison covalente n'est créée entre le film composite et le substrat.

La face avant de la membrane peut être structurée dans la zone 32A. Cela améliore l'adhésion du film composite sur cette zone 32A de la membrane 14.

Les étapes 72 à 88 pour transférer une partie de film composite sur la membrane peuvent être réitérées plusieurs fois afin de transférer successivement plusieurs parties de film composite sur la même membrane. Cela permet notamment de réaliser sur la membrane 14 un empilement de plusieurs films composites les uns au-dessus des autres. Pour cela, à chaque nouvelle itération des étapes 72 à 88, la zone 32A est confondue avec la face 36 de la partie du film composite précédemment transférée. Dans cet empilement, les films composites peuvent être tous identiques les uns aux autres, ou au contraire, différer les uns des autres, par exemple, par la nature de leurs nanoparticules.

Éventuellement, lors de l'étape 72, le matériau 172 ne remplit pas totalement les cavités 166. Cette absence de remplissage complet des cavités provient, par exemple, de la viscosité de la solution colloïdale utilisée lors de cette étape.

Les modes de réalisation décrits jusqu'à présent l'ont été dans le cas particulier de films composites comportant seulement des nanoparticules. Toutefois, tout ce qui a été décrit s'applique aussi à des films composites dans lesquels les particules dispersées à l'intérieur de la matrice ont un exo-diamètre pouvant atteindre jusqu'à 10 µm ou 30 µm ou 100 µm. Dans ce cas, l'épaisseur du film est adaptée pour qu'elle soit strictement supérieure, et de préférence deux ou trois fois supérieure, à l'exo-diamètre des plus grosses particules de ce film. Lorsque l'exo-diamètre EDₘₐₓ des plus grosses particules dépasse 1 µm ou 10 µm, il peut être avantageux de conserver l'exo-diamètre des particules moins grosses supérieur à EDₘₐₓ/100 ou EDₘₐₓ/10 pour limiter l'étendue de la répartition des exo-diamètres des particules.

## Revendications

1. Procédé de transfert d'au moins une partie d'un film composite sur une membrane souple en polymère, le film composite comportant une matrice en polymère thermoplastique à l'intérieur de laquelle sont dispersées des particules conférant à ce film composite des propriétés physiques, l'exo-diamètre des particules étant compris entre 1 nm et 100 µm, et le volume des particules à l'intérieur du film composite représentant plus de 1 % du volume de ce film composite, ce procédé comportant :
α) le dépôt (72) du film composite directement sur un substrat rigide en un matériau autre qu'un polymère et dont l'épaisseur est strictement supérieure à l'épaisseur du film composite, le film composite présentant alors une face extérieure tournée du côté opposé au substrat rigide, puis
β) le transfert d'au moins une partie du film composite déposé sur le substrat rigide vers la membrane par tamponnage,
**caractérisé en ce que** lors l'étape β) la membrane souple est utilisée comme un tampon et comporte pour cela les opérations suivantes :
1) le déplacement de la membrane à la fois :
- dans une position montée dans laquelle une partie centrale de la membrane obture de façon étanche à un fluide une ouverture d'un réservoir, cette portion centrale présentant alors une face arrière directement exposée à l'intérieur du réservoir et une face avant du côté opposé, et
- dans une position active dans laquelle une première zone de la face avant est directement en contact sur la face extérieure du film composite,
2) le chauffage (80) du film composite pour que sa température dépasse la température de transition vitreuse de sa matrice, de manière à le ramollir,
3) lorsque le film composite est ramolli et que la membrane est à la fois dans sa position montée et dans sa position active, le fluide à l'intérieur du réservoir comprime (82) uniformément la première zone contre la face extérieure du film composite pour coller cette première zone sur cette face extérieure avec une force d'adhésion supérieure à la force d'adhésion qui retient le film composite sur son substrat rigide, puis
4) le déplacement (88) de la membrane depuis sa position active vers une position rétractée dans laquelle sa face avant est plus éloignée du substrat rigide que dans sa position active, ce déplacement de la membrane de sa position active vers sa position rétractée séparant, du substrat rigide, la partie du film composite collée sur la première zone.

2. Procédé selon la revendication 1, dans lequel :
- le procédé comporte également la fourniture d'un tampon en un matériau autre qu'un polymère et qui est placé sur la face avant de la membrane, ce tampon recouvrant complètement une seconde zone de la face avant tout en laissant la première zone de cette face avant directement exposée à l'extérieur et la face avant de ce tampon présentant une aptitude à adhérer sur la face extérieure du film composite, inférieure à la force d'adhésion qui retient le film composite sur le substrat rigide,
- lors de l'opération 3) (82), le tampon est interposé entre la membrane et la face extérieure du film composite pour empêcher que la seconde zone de la face avant vienne se coller sur cette face extérieure du film composite, et
- lors de l'opération 4) (88), la partie du film composite en vis-à-vis du tampon reste solidaire du substrat rigide.

3. Procédé selon la revendication 2, dans lequel :
- avant l'étape a), le procédé comprend la réalisation (180) d'une cavité dans la face du substrat rigide sur laquelle va être déposé le film composite, puis
- lors de l'étape β), le tampon est disposé sur la face avant de manière à se trouver en face de la cavité lors de l'opération 3) (88).

4. Procédé selon l'une quelconque des revendications précédentes, dans lequel entre les opérations 3) et 4), le procédé comporte le refroidissement (84) du film composite en dessous de la température de transition vitreuse pour le durcir à nouveau et l'opération 4) est exécutée lorsque la température du film composite est inférieure à la température de transition vitreuse.

5. Procédé de fabrication, sur une membrane souple en polymère, d'un composant comportant un film composite, ce procédé comportant :
a) le dépôt (112) d'au moins une partie d'un film composite sur la membrane, et
b) le dépôt (120) d'une couche fonctionnelle sur la face extérieure de ladite au moins une partie du film composite déposée sur la membrane, cette couche fonctionnelle étant nécessaire au fonctionnement du composant,
**caractérisé en ce que** l'étape a) comporte le transfert (118) de ladite au moins une partie du film composite sur la membrane en mettant un œuvre un procédé conforme à l'une quelconque des revendications 1 à 4.

6. Procédé selon la revendication 5, dans lequel la face du substrat rigide sur laquelle est déposé le film composite lors de l'étape a) du procédé de transfert, est lisse c'est-à-dire que cette face présente uniquement des aspérités aléatoirement réparties sur toute sa surface et de dimension telle que la rugosité RMS (« Root Mean Square ») de la face lisse est inférieure à l'exo-diamètre moyen des particules dispersées dans le film composite.

7. Procédé selon la revendication 6, dans lequel, la rugosité RMS de la face lisse est inférieure à 100 nm ou 50 nm.

8. Procédé selon l'une quelconque des revendications 5 à 7, dans lequel, entre les étapes a) et b), le procédé comporte le démontage (92) de la membrane du réservoir pour réaliser l'étape b) sur la membrane désolidarisée du réservoir.

9. Procédé de fabrication, sur un substrat rigide en un matériau autre qu'un polymère, d'un composant comportant un film composite, ce procédé comportant :
a) le dépôt (72) du film composite directement sur le substrat rigide, puis
b) l'élimination (142 ; 182) d'une première partie du film composite déposé sur le substrat rigide pour mettre à nu la face du substrat rigide qui se trouve directement sous cette première partie,
**caractérisé en ce que** l'étape b) est réalisée en transférant la première partie du film composite sur une membrane souple en polymère en mettant en œuvre un procédé de transfert conforme à la revendication 2 dans lequel la première zone vient directement en contact sur toute la première partie du film composite et le tampon recouvre entièrement la ou les parties du film composite qui doivent rester solidaire du substrat rigide.

10. Procédé selon la revendication 9, dans lequel la face avant du tampon est lisse, c'est-à-dire que cette face avant présente uniquement des aspérités aléatoirement réparties sur toute sa surface et de dimension telle que la rugosité RMS (« Root Mean Square ») de la face lisse est inférieure à l'exo-diamètre moyen des particules dispersées dans le film composite.

11. Procédé selon la revendication 10, dans lequel, la rugosité RMS de la face lisse est inférieure à 100 nm ou 50 nm.

12. Procédé selon la revendication 9, dans lequel le tampon comporte des motifs gravés dans sa face avant.

13. Procédé selon l'une quelconque des revendications 9 à 12, dans lequel, après l'étape b), le procédé comporte une étape c) de dépôt (144) d'une couche fonctionnelle directement sur la face extérieure de la partie du film composite restée solidaire du substrat rigide, cette couche fonctionnelle étant nécessaire au fonctionnement du composant.

## Patentansprüche

1. Verfahren zur Übertragung zumindest eines Abschnitts einer Verbundstofffolie auf eine nachgiebige Polymermembran, wobei die Verbundstofffolie eine Matrix aus thermoplastischem Polymer aufweist, in deren Innerem Partikel dispergiert sind, welche dieser Verbundstofffolie physikalische Eigenschaften verleihen, wobei der Außendurchmesser der Partikel im Bereich von 1 nm bis 100 µm liegt und das Volumen der Partikel im Inneren der Verbundstofffolie mehr als 1 % des Volumens dieser Verbundstofffolie ausmacht, wobei das Verfahren Folgendes aufweist:
α) Aufbringen (72) der Verbundstofffolie unmittelbar auf ein steifes Substrat aus einem Material, das kein Polymer ist, wobei dessen Dicke streng größer als die Dicke der Verbundstofffolie ist, woraufhin die Verbundstofffolie eine Außenfläche aufweist, die dem steifen Substrat abgewandt ist, und danach
β) Übertragen zumindest eines Abschnitts der Verbundstofffolie, welche auf das steife Substrat aufgebracht wurde, mittels Auftupfen,
**dadurch gekennzeichnet, dass** im Schritt β) die nachgiebige Membran wie ein Tupfer verwendet wird und zu diesem Zwecke die folgenden Vorgänge aufweist:
1) Verschieben der Membran:
- sowohl in eine montierte Position, in welcher ein mittiger Abschnitt der Membran eine Öffnung eines Vorratsbehälters derart verschließt, dass sie fluiddicht ist, woraufhin dieser mittige Abschnitt eine rückseitige Fläche, die unmittelbar dem Innenraum des Vorratsbehälters ausgesetzt ist, und eine gegenüberliegende vorderseitige Fläche aufweist, als auch
- in eine aktive Position, in welcher ein erster Bereich der vorderseitigen Fläche unmittelbar mit der Außenfläche der Verbundstofffolie in Kontakt ist,
2) Erwärmen (80) der Verbundstofffolie, sodass ihre Temperatur die Glasübergangstemperatur ihrer Matrix übersteigt, woraufhin sie erweicht,
3) wenn die Verbundstofffolie erweicht ist und die Membran sich sowohl in ihrer montierten Position als auch in ihrer aktiven Position befindet, drückt (82) das Fluid, welches sich im Innenraum des Vorratsbehälters befindet, den ersten Bereich auf gleichförmige Weise gegen die Außenfläche der Verbundstofffolie, um diesen ersten Bereich auf diese Außenfläche zu kleben, mit einer Haftkraft, die größer als die Haftkraft ist, welche die Verbundstofffolie auf ihrem steifen Substrat hält, woraufhin
4) die Membran aus ihrer aktiven Position in Richtung einer zurückgezogenen Position verschoben (88) wird, in welcher ihre vorderseitige Fläche weiter vom steifen Substrat entfernt ist als in ihrer aktiven Position, wobei diese Verschiebung der Membran von ihrer aktiven Position in ihre zurückgezogene Position bewirkt, dass sich der Abschnitt der Verbundstofffolie, welcher auf den ersten Bereich geklebt ist, vom steifen Substrat trennt.

2. Verfahren nach Anspruch 1, wobei:
- das Verfahren weiterhin das Bereitstellen eines Tupfers aus einem Material, das kein Polymer ist, aufweist, wobei dieser auf die vorderseitigen Fläche der Membran angeordnet wird, wobei dieser Tupfer einen zweiten Bereich der vorderseitigen Fläche vollständig bedeckt und zugleich zulässt, dass der Außenraum unmittelbar auf den ersten Bereich dieser vorderseitigen Fläche einwirkt, und wobei die vorderseitige Fläche dieses Tupfers eine Fähigkeit aufweist, auf der Außenfläche der Verbundstofffolie anzuhaften, die geringer als die Haftkraft ist, welche die Verbundstofffolie auf dem steifen Substrat hält,
- der Tupfer beim Vorgang 3) (82) zwischen der Membran und der Außenfläche der Verbundstofffolie angeordnet ist, um zu verhindern, dass der zweite Bereich die vorderseitige Fläche an dieser Außenfläche der Verbundstofffolie anklebt, und
- der Abschnitt der Verbundstofffolie, welcher dem Tupfer zugewandt ist, beim Vorgang 4) (88) mit dem steifen Substrat fest verbunden bleibt.

3. Verfahren nach Anspruch 2, wobei:
- im Rahmen des Verfahrens, vor dem Schritt a), in der Fläche des steifen Substrats, auf welcher die Verbundstofffolie aufgebracht werden wird, ein Hohlraum geschaffen (180) wird, woraufhin
- der Tupfer im Schritt β) derart auf der vorderseitigen Fläche angeordnet wird, dass er beim Vorgang 3) (88) dem Hohlraum gegenüberliegt.

4. Verfahren nach einem beliebigen der vorhergehenden Ansprüche, wobei im Rahmen des Verfahrens, zwischen den Vorgängen 3) und 4), die Verbundstofffolie unter ihre Glasübergangstemperatur abgekühlt (84) wird, damit sie wieder aushärtet, und der Vorgang 4) ausgeführt wird, wenn die Temperatur der Verbundstofffolie geringer als die Glasübergangstemperatur ist.

5. Verfahren zur Herstellung, auf einer nachgiebigen Polymermembran, eines Bauelements, das eine Verbundstofffolie aufweist, wobei das Verfahren Folgendes aufweist:
a) Aufbringen (112) zumindest eines Abschnitts einer Verbundstofffolie auf die Membran, und
b) Aufbringen (120) einer Funktionslage auf die Außenfläche zumindest des genannten Abschnitts der Verbundstofffolie, welche auf die Membran aufgebracht wurde, wobei diese Funktionslage notwendig ist, damit das Bauelement seine Aufgabe erfüllen kann,
**dadurch gekennzeichnet, dass** im Rahmen des Schrittes a) zumindest der genannte Abschnitt der Verbundstofffolie auf die Membran übertragen (118) wird, indem ein Verfahren gemäß einem beliebigen der Ansprüche 1 bis 4 umgesetzt wird.

6. Verfahren nach Anspruch 5, wobei die Fläche des steifen Substrats, auf welche im Schritt a) des Übertragungsverfahrens die Verbundstofffolie aufgebracht wird, glatt ist, das heißt, dass diese Fläche ausschließlich Unebenheiten aufweist, die zufällig über ihre gesamte Oberfläche und Abmessung verteilt sind, sodass der RMS-Wert der Rauigkeit ("Root Mean Square") der glatten Fläche geringer als der Außendurchmesser der Partikel ist, welche in der Verbundstofffolie dispergiert sind.

7. Verfahren nach Anspruch 6, wobei der RMS-Wert der Rauigkeit der glatten Fläche geringer als 100 nm oder 50 nm ist.

8. Verfahren nach einem beliebigen der Ansprüche 5 bis 7, wobei im Rahmen des Verfahrens, zwischen den Schritten a) und b), die Membran vom Vorratsbehälter abgenommen (92) wird, um den Schritt b) auf der Membran durchzuführen, nachdem diese vom Vorratsbehälter gelöst wurde.

9. Verfahren zur Herstellung, auf einem steifen Substrat aus einem Material, das kein Polymer ist, eines Bauelements, das eine Verbundstofffolie aufweist, wobei das Verfahren Folgendes aufweist:
a) Aufbringen (72) der Verbundstofffolie unmittelbar auf das steife Substrat, und danach
b) Entfernen (142; 182) eines ersten Abschnitts der Verbundstofffolie, welche auf das steife Substrat aufgebracht wurde, damit die Fläche des steifen Substrats, welche sich unmittelbar unter diesem ersten Abschnitt befindet, nunmehr unbedeckt ist,
**dadurch gekennzeichnet, dass** der Schritt b) durchgeführt wird, indem der erste Abschnitt der Verbundstofffolie auf eine nachgiebige Polymermembran übertragen wird, wobei zu diesem Zwecke ein Übertragungsverfahren gemäß dem Anspruch 2 durchgeführt wird, in welchem der erste Bereich unmittelbar über den gesamten ersten Abschnitt der Verbundstofffolie in Kontakt kommt und der Tupfer den oder die Abschnitte der Verbundstofffolie vollständig bedeckt, welche fest mit dem steifen Substrat verbunden bleiben müssen.

10. Verfahren nach Anspruch 9, wobei die vorderseitige Fläche des Tupfers glatt ist, das heißt, dass diese vorderseitige Fläche ausschließlich Unebenheiten aufweist, die zufällig über ihre gesamte Oberfläche und Abmessung verteilt sind, sodass der RMS-Wert der Rauigkeit ("Root Mean Square") der glatten Fläche geringer als der Außendurchmesser der Partikel ist, welche in der Verbundstofffolie dispergiert sind.

11. Verfahren nach Anspruch 10, wobei der RMS-Wert der Rauigkeit der glatten Fläche geringer als 100 nm oder 50 nm ist.

12. Verfahren nach Anspruch 9, wobei der Tupfer Motive aufweist, die in seine vorderseitige Fläche eingraviert sind.

13. Verfahren nach einem beliebigen der Ansprüche 9 bis 12, wobei das Verfahren, nach dem Schritt b) einen Schritt c) aufweist, der darin besteht, eine Funktionslage unmittelbar auf die Außenfläche desjenigen Abschnitts der Verbundstofffolie aufzubringen (144), welcher fest mit dem steifen Substrat verbunden geblieben ist, wobei diese Funktionslage notwendig ist, damit das Bauelement seine Aufgabe erfüllen kann.

## Claims

1. Process for the transfer of at least a portion of a composite film onto a flexible polymer membrane, the composite film comprising a matrix made of thermoplastic polymer inside which are dispersed particles conferring physical properties on this composite film, the exodiameter of the particles being between 1 nm and 100 µm and the volume of the particles inside the composite film representing more than 1% of the volume of this composite film, this process comprising:
α) the deposition (72) of the composite film directly on a rigid substrate made of a material other than a polymer and having a thickness strictly greater than the thickness of the composite film, the composite film then exhibiting an external face turned the opposite way from the rigid substrate, then
β) the transfer of at least a portion of the composite film deposited on the rigid substrate to the membrane by stamping,
**characterized in that**, during stage β), the flexible membrane is used as a buffer and comprises, for this, the following operations:
1) the movement of the membrane both:
- into an assembled position in which a central portion of the membrane closes up, in a way leaktight to a fluid, an opening of a reservoir, this central section then exhibiting a rear face directly exposed to the inside of the reservoir and a front face on the opposite side, and
- into an active position in which a first zone of the front face is directly in contact on the external face of the composite film,
2) the heating (80) of the composite film in order for its temperature to exceed the glass transition temperature of its matrix, so as to soften it,
3) when the composite film is softened and when the membrane is both in its assembled position and in its active position, the fluid inside the reservoir uniformly compresses (82) the first zone against the external face of the composite film in order to adhesively bond this first zone to this external face with an adhesive force greater than the adhesive force which holds the composite film on its rigid substrate, then
4) the movement (88) of the membrane from its active position to a retracted position in which its front face is further from the rigid substrate than in its active position, this movement of the membrane from its active position to its retracted position separating, from the rigid substrate, the portion of the composite film adhesively bonded to the first zone.

2. Process according to Claim 1, in which:
- the process also comprises the provision of a buffer made of a material other than a polymer and which is placed on the front face of the membrane, this buffer completely covering a second zone of the front face while leaving the first zone of this front face directly exposed to the outside and the front face of this buffer exhibiting an ability to adhere to the external face of the composite film which is lower than the adhesive force which holds the composite film on the rigid substrate,
- during operation 3), (82) the buffer is interposed between the membrane and the external face of the composite film in order to prevent the second zone of the front face from adhesively bonding to this external face of the composite film, and
- during operation 4), (88) the portion of the composite film facing the buffer remains attached to the rigid substrate.

3. Process according to Claim 2, in which:
- before stage a), the process comprises the preparation (180) of a cavity in the face of the rigid substrate on which the composite film will be deposited, then
- during stage β), the buffer is positioned on the front face so as to be facing the cavity during operation 3) (88).

4. Process according to any one of the preceding claims, in which, between operations 3) and 4), the process comprises the cooling (84) of the composite film below the glass transition temperature in order to again harden it and operation 4) is carried out when the temperature of the composite film is lower than the glass transition temperature.

5. Process for manufacturing, on a flexible polymer membrane, a component comprising a composite film, this process comprising:
a) the deposition (112) of at least a portion of a composite film on the membrane, and
b) the deposition (120) of a functional layer on the external face of the said at least one portion of the composite film deposited on the membrane, this functional layer being necessary for the operation of the component,
**characterized in that** stage a) comprises the transfer (118) of the said at least one portion of the composite film onto the membrane by employing a process in accordance with any one of Claims 1 to 4.

6. Process according to Claim 5, in which the face of the rigid substrate on which the composite film is deposited during stage a) of the transfer process is smooth, that is to say that this face exhibits solely unevennesses randomly distributed over the whole of its surface and with a dimension such that the RMS (Root Mean Square) roughness of the smooth face is less than the mean exodiameter of the particles dispersed in the composite film.

7. Process according to Claim 6, in which the RMS roughness of the smooth face is less than 100 nm or 50 nm.

8. Process according to any one of Claims 5 to 7, in which, between stages a) and b), the process comprises the dismantling (92) of the membrane from the reservoir in order to carry out stage b) on the membrane detached from the reservoir.

9. Process for the manufacture, on a rigid substrate made of a material other than a polymer, of a component comprising a composite film, this process comprising:
a) the deposition (72) of the composite film directly on the rigid substrate, then
b) the removal (142; 182) of a first portion of the composite film deposited on the rigid substrate in order to render bare the face of the rigid substrate which is directly under this first portion,
**characterized in that** stage b) is carried out by transferring the first portion of the composite film onto a flexible polymer membrane by employing a transfer process in accordance with Claim 2 in which the first zone comes directly into contact over the whole of the first portion of the composite film and the buffer completely covers the portion or portions of the composite film which have to remain attached to the rigid substrate.

10. Process according to Claim 9, in which the front face of the buffer is smooth, that is to say that this front face exhibits solely roughnesses randomly distributed over the whole of its surface and with a dimension such that the RMS (Root Mean Square) roughness of the smooth face is less than the mean exodiameter of the particles dispersed in the composite film.

11. Process according to Claim 10, in which the RMS roughness of the smooth face is less than 100 nm or 50 nm.

12. Process according to Claim 9, in which the buffer comprises patterns etched in its front face.

13. Process according to any one of Claims 9 to 12, in which, after stage b), the process comprises a stage c) of deposition (144) of a functional layer directly on the external face of the portion of the composite film which has remained attached to the rigid substrate, this functional layer being necessary for the operation of the component.
